Europäisches Patentamt

European Patent Office

Office européen des brevets

(19)

(11) **EP 1 482 643 B1**

(12) # EUROPEAN PATENT SPECIFICATION

(45) Date of publication and mention
of the grant of the patent:
**19.07.2006 Bulletin 2006/29**

(51) Int Cl.:
***H03M 13/11*** *(2006.01)*

(21) Application number: **04012500.7**

(22) Date of filing: **26.05.2004**

(54) **Method and apparatus for decoding a low density parity check (LDPC) code in a communication system**

Verfahren und Vorrichtung zur Decodierung eines Low Density Partity Check (LDPC) Codes in einem Kommunikationssystem

Procédé et appareil pour décodage de code LDPC dans un système de communication

(84) Designated Contracting States:
**DE FI FR GB IT SE**

(30) Priority: **26.05.2003 KR 2003033456**

(43) Date of publication of application:
**01.12.2004 Bulletin 2004/49**

(73) Proprietors:
- **SAMSUNG ELECTRONICS CO., LTD.**
  **Suwon-si,**
  **Gyeonggi-do (KR)**
- **Yonsei University**
  **Seoul (KR)**

(72) Inventors:
- **Suh, Seung-Bum**
  **c/o Samsung Electronics Co., Ltd.**
  **Suwon-si**
  **Gyeonggi-do (KR)**
- **Song, Hong-Yeop**
  **c/o Samsung Electronics Co., Ltd.**
  **Suwon-si**
  **Gyeonggi-do (KR)**
- **Shin, Min-Ho**
  **Yonsei University**
  **Seodaemun-gu**
  **Seoul (KR)**
- **Kim, Joon-Sung**
  **Yonsei University**
  **Seodaemun-gu**
  **Seoul (KR)**

(74) Representative: **Grünecker, Kinkeldey, Stockmair & Schwanhäusser Anwaltssozietät Maximilianstrasse 58 80538 München (DE)**

(56) References cited:
**US-A1- 2003 229 843**

- **CHEN J ET AL: "NEAR OPTIMUM UNIVERSAL BELIEF PROPAGATION BASED DECODING OF LOW-DENSITY PARITY CHECK CODES" IEEE TRANSACTIONS ON COMMUNICATIONS, IEEE INC. NEW YORK, US, vol. 50, no. 3, March 2002 (2002-03), pages 406-414, XP001115193 ISSN: 0090-6778**
- **FOSSORIER M P C ET AL: "Reduced complexity iterative decoding of low-density parity check codes based on belief propagation" IEEE TRANSACTIONS ON COMMUNICATIONS, IEEE INC. NEW YORK, US, vol. 47, no. 5, May 1999 (1999-05), pages 673-680, XP002313256 ISSN: 0090-6778**
- **FOSSORIER M P C: "Iterative reliability-based decoding of low-density parity check codes" IEEE JOURNAL ON SELECTED AREAS IN COMMUNICATIONS, IEEE INC. NEW YORK, US, vol. 19, no. 5, May 2001 (2001-05), pages 908-917, XP001101010 ISSN: 0733-8716**

EP 1 482 643 B1

- **LEVINE B ET AL: "Implementation of near Shannon limit error-correcting codes using reconfigurable hardware" PROC., IEEE SYMPOSIUM ON FIELD-PROGRAMMABLE CUSTOM COMPUTING MACHINES, NAPA VALLEY, CA, USA, 17 April 2000 (2000-04-17), pages 217-226, XP010531940 ISBN: 0-7695-0871-5**

- **CHEN J. AND FOSSORIER M.P.C.: "Density evolution for two improved BP-based decoding algorithms of LDPC codes" IEEE COMMUNICATIONS LETTERS, vol. 6, no. 5, May 2002 (2002-05), pages 208-210, XP002320747**

**Description**

**BACKGROUND OF THE INVENTION**

1. Field of the Invention

The present invention relates generally to a Forward Error Correction (FEC) apparatus and method for use in a digital communication system, and more particularly to an apparatus and method for decoding an FEC code in a digital communication system for transmitting high-speed data.

2. Description of the Related Art

Conventionally, digital communication systems generates many errors due to noise generated from a transmission path. Accordingly, over the years, a variety of solutions have been presented to correct or eliminate these errors. A wireless communication system based on the 3GPP or 3GPP2 specification proposed using convolutional codes to transmit voice and control signals, and also proposed using turbo codes to effectively transmit high-speed data. The turbo code for high-speed data transmission has an advantage in that it has an extremely low BER (Bit Error Rate) at a low SNR (Signal to Noise Ratio), but it has a number of disadvantages in its performance and implementation.

Firstly, the turbo code has a relatively short minimum distance of a codeword. Therefore, when decoding a signal coded with the turbo code, there may arise an error floor at a desired BER location. The turbo code has another disadvantage in that it has a relatively high undetected error probability in association with a codeword for generating errors in a decoding mode.

Secondly, a decoding process of the turbo code requires an effective decoding stop function to reduce not a decoding time and its power consumption, such that it requires either a CRC (Cyclic Redundancy Check) process to detect errors for every iterative decoding process, or an additional algorithm to perform a decoding stop process, resulting in implementation of an effective decoding stop function.

Thirdly, an algorithm for decoding the turbo code cannot be implemented in the form of a parallel architecture, resulting in limitation in improving a decoding speed.

Therefore, recently, an LDPC (Low Density Parity Check) code, which has excellent performance and functions as a new code capable of solving the aforementioned problems, has been developed. The LDPC code contains a very small number of a specific number "1" in individual rows and columns of a parity check matrix for code definition, and its architecture can be defined by a factor graph comprising a check node, a variable node, and an edge for interconnecting the check node and the variable node. The LDPC code has a longer minimum distance as compared to the turbo code, such that an error floor occurs at a very lower BER as compared to the turbo code and undetected error probability for an erroneous codeword is a very low value experimentally approximating zero. Additionally, the LDPC code can be implemented in the form of a parallel architecture, resulting in a reduced decoding time. The LDPC code can perform an effective decoding stop function without using either an overhead, such as a CRC, or a specific decoding stop algorithm having been added through the use of a parity check process performed for each iterative decoding process.

The LDPC code is a linear block code in which most elements of a parity check matrix H are each equal to '0', and uses a probable iterative decoding method using a simple parity check equation, resulting in improvement of performance. The decoding method for the LDPC is designed to search for the most probable codeword by which the multiplication of a reception signal vector and a parity check matrix satisfies a specific value of '0'.

A Sum-Product algorithm acting a representative LDPC-code decoding method performs a soft-decision iterative decoding process using a probability value to search for the above codeword. More specifically, the Sum-Product algorithm updates a probability value of each bit using a reception vector and a channel characteristic for every iterative decoding process, such that it can search for a codeword having the multiplied result '0' associated with the parity check matrix.

Another LDPC-code decoding method is an LLR-Belicf Propagation (LLR-BP) algorithm for calculating a message propagated using an LLR (Log-Likelihood Ratio). Except for one characteristic in which the LLR value is used instead of a real probability value during the calculation time of the propagation message, the LLR-BP algorithm can be considered to be the same algorithm as the Sum-Product algorithm. The LLR-BP algorithm has excellent performance because it approximates Shannon's theoretical channel capacitance boundary on the assumption that the length of a codeword is sufficiently long. However, the LLR-BP algorithm uses a log function and a hyper-tangent (tanh) function for use in the iterative decoding process, thereby increasing calculation complexity and difficulty in its real implementation.

Accordingly, improved algorithms have been proposed by Chen and Fossorier et al., who have published a research paper entitled "REDUCED COMPLEXITY ITERATIVE DECODING OF LOW DENSITY PARITY CHECK CODES BASED ON BELIEF PROPAGATION" in the IEEE trans. Commun., vol. 47, pp. 673-680 on May 1999.

The above algorithms are a UMP-BP (Uniformly Most Powerful-Belief Propagation) algorithm and a Normalized-BP (Normalized-Belief Propagation) algorithm, which reduce iterative decoding complexity and encounter less performance deterioration as compared to the conventional LLR-BP algorithm. The UMP-BP algorithm prevents a log function and a tanh function from being used in a row-directional iterative decoding process of the LLR-BP algorithm, selects a bit value having the lowest LLR from among a plurality of bits associated with a given parity check equation, and approximates the selected bit value, considerably reduced complexity. The Normalized-BP algorithm approximates the row-directional iterative decoding process in the same manner as in the UMP-BP algorithm, largely reducing calculation complexity. The UMP-BP method has introduced a standardized factor concept, such that it prevents a message value from being higher than that of the LLR-BP algorithm due to the LLR omission in such approximation. Therefore, the UMP-BP algorithm can implement performance similar to that of the LLR-BP algorithm. The UMP-BP algorithm adapts a specific omission part to reduce complexity, such that its bit-average LLR is higher than that of the LLR-BP algorithm. Therefore, the Normalized-BP algorithm adapts a normalization factor alpha scheme to reduce the difference between the above two LLRs, such that it allows an average value of individual LLRs to be similar to that of the LLR-BP algorithm, resulting in excellent performance superior to that of the UMP-BP algorithm.

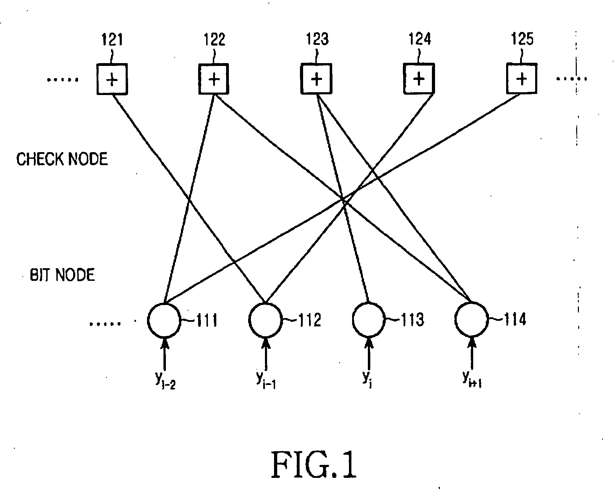

Fig. 1 is a conceptual diagram illustrating a relationship between check nodes and variable nodes to explain a factor process for decoding the LDPC code. Referring to Fig. 1, symbols coded by the LDPC code matrix are transmitted via wireless channel environments, and individual coded symbols enter bit nodes (..., 111, 112, 113, 114, ...). The bit nodes (..., 111, 112, 113, 114, ...) receive LLR values of entry coded symbols, and transmit the received LLR values to individual check nodes (..., 121, 122, 123, 124, 125, ...). Individual check nodes (..., 121, 122, 123, 124, 125, ...) perform their operations using different using the aforementioned methods, and transmit the operation results to the bit nodes (..., 111, 112, 113, 114, ...). It is determined whether the values transmitted to the bit nodes (..., 111, 112, 113, 114, ...) satisfy parity check requirements in a temporary decoding process. If it is determined that the parity check requirements have been satisfied, a decoding process for corresponding symbols is terminated. However, if it is determined that the parity check requirements have not been satisfied, values to be detected are re-calculated using a transmission/operation method between bit nodes (..., 111, 112, 113, 114, ...) and check nodes (..., 121, 122, 123, 124, 125, ...).

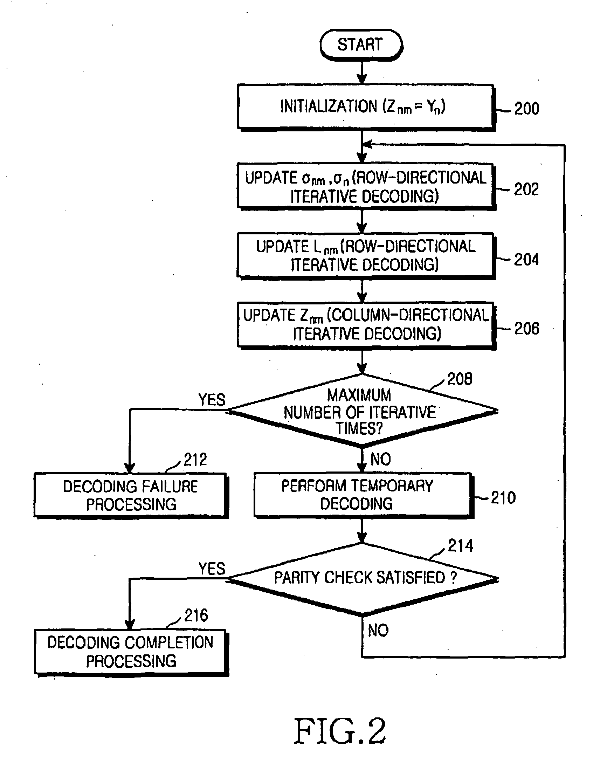

Fig. 2 is a flow chart illustrating the Normalized-BP algorithm. Referring to Fig. 2, upon receiving coded symbols from a wireless channel, the LDPC decoder performs an initialization process at step 200. The initialization process determines values $Z_{mn}$ of bit nodes, and determines the values $Z_{mn}$ to be values of individual initial-entry coded symbols $y_n$. The values $Z_{mn}$ of the bit nodes identify an LLR ranging from a bit node N to a check node m. After finishing the initial value setup process, individual bit nodes (..., 111, 112, 113, 115, ...) of the LDPC decoder perform operations for bits to be calculated in a row-directional iterative decoding process at step 202. Such operation determines an initial-entry value as shown in Equation 1, and operates a modulo-2-sum operation of the remaining bits using all parity check equations associated with bits to be calculated on the basis of the determined values.

[Equation 1]

$$\sigma_{mn} = \begin{cases} 1, & \text{if } z_{mn} > 0 \\ 0, & \text{if } z_{mn} \le 0 \end{cases}, \quad \sigma_m = \sum_{n \in N(m)} \sigma_{mn} \bmod 2$$

Referring to Equation 1, $\sigma_{mn}$ is represents values received from a bit node 'n' to an m-th check node, and $\sigma_m$ is a value determined by an m-th bit node.

After performing the aforementioned calculation, individual bit nodes (..., 111, 112, 113, 115, ...) select their codes using the calculated value so as to enable a parity check equation to satisfy the value '0'. Thereafter, the LDPC decoder calculates LLR values of individual selection codes of the bit nodes (..., 111, 112, 113, 115, ...) using Equation 2 at step 204. Equation 2 corrects a mean message value using the aforementioned standardized factor.

[Equation 2]

$$L_{mn} = (-1)^{\overline{\sigma_m \oplus \sigma_{mn}}} \min_{n' \in N(m) \backslash n} \left| z_{mn'} \right| / \alpha$$

The row-directional iterative decoding process shown in Equation 2 integrates an initially-received value and calculation values of individual parity check equations as one value, such that it determines a bit code to be calculated. Equation 2 represents a row-directional iterative decoding process for the Normalized-BP algorithm, where $Z_{mn}$ is an

LLR of the bit 'n' propagated from the bit 'n' to a parity check equation 'm', and $\alpha$ is a standardized factor for use in the Normalized-BP algorithm. During the initial driving time of the Normalized-BP algorithm, LLR values of individual bits are initialized to a reception value. If codes of all bits have been determined using the aforementioned process, the LDPC decoder performs a column-directional iterative decoding process at step 206. In this case, the column-directional iterative decoding process is a process for updating the value of $Z_{mn}$, and it can be represented by the Equation 3:

[Equation 3]

$$ Z_{mn} = y_n + \sum_{m' \in M(n) \backslash m} L_{m'n} $$

If the column-directional iterative decoding process can be carried out using Equation 3, the LDPC decoder determines whether the number of iterative decoding times is equal to a prescribed maximum number of iterative decoding times at step 208. The maximum number of iterative decoding times is used to halt the decoding operation on the condition that very-low decoding success probability is provided when continuously performing an iterative decoding operation. If the LDPC decoder has performed the decoding operation the maximum decoding times at step 208, it performs a decoding failure process at step 212. However, if the LDPC decoder not has performed the decoding operation the maximum decoding times, it performs a temporary decoding process at step 210. The temporary decoding process can be performed using Equation 4:

[Equation 4]

$$ Z_n = y_n + \sum_{m \in M(n)} L_{mn} \, , \quad \begin{cases} \hat{c} = 1 & if \ Z_n > 0 \\ \hat{c} = 0 & if \ Z_n < 0 \end{cases} $$

The value of $Z_n$ can be calculated using Equation 4, such that values of $\hat{c}$ of code symbols are determined, the LDPC decoder performs a parity cheek such that it determines whether a parity check result is satisfied or not at step 214. The parity check is identifies a matrix in which the reception coded symbols must satisfy a predetermined condition of Equation 5, such that its result can be recognized by determining whether the coded symbols satisfy the predetermined condition of Equation 5:

[Equation 5]

$$ H\hat{c} = 0 $$

If the parity check result of Equation 5 identifies a good state, i.e., in the case of passing the parity check process, the LDPC decoder terminates the decoding process for corresponding symbols at step 216. However, when the parity check process is not satisfied, the LDPC decoder returns to step 202 to re-perform the aforementioned steps, such that the iterative decoding steps are continuously performed.

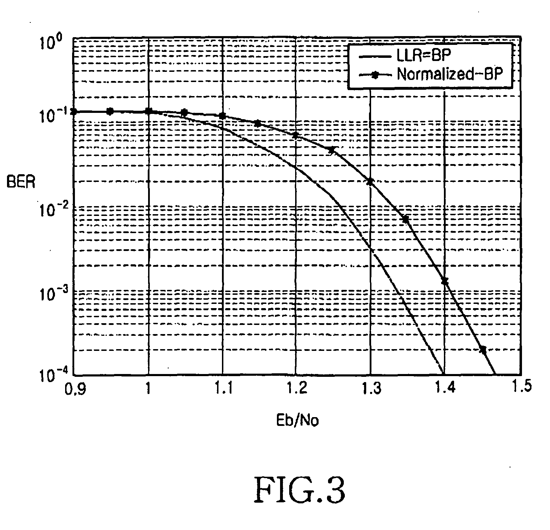

The Normalized-BP algorithm considerably reduces complexity as compared to the LLR-BP algorithm. However, the Normalized-HP algorithm encounters greater BER performance deterioration as compared to the LLR-BP algorithm. Fig. 3 is a simulation result graph for the comparison between performances according to methods for decoding an LDPC code having a block length of 20000. Referring to Fig. 3, the BER of theNormalized-BP algorithm is less than that of the LLR-BP algorithm by about 0.07 dB. More specifically, the Normalized-BP algorithm has a disadvantage in that it unavoidably encounters performance deterioration.

In "Near Optimum Universal Belief Propagation Based Decoding of Low-Density Parity Check Codes", published in IEEE Transactions on Communications, vol. 50, no. 3, of March 2002, a belief propagation based decoding algorithm is proposed which utilizes normalization to improve the accuracy of the soft values. Therein is shown how to obtain the normalization factors by simulations and a way is given to find therm theoretically.

In "Reduced Complexity Iterative Decoding of Low-Density Parity Check Codes Based on Belief Propagation" in the IEEE Transactions on Communications, vol. 7, no. 5 of May 1999, two simplified versions of the belief propagation algorithm for fast iterative decoding of low-density parity check codes on the additive white Gaussian noise channel are proposed. Both algorithms require real additions only.

In "Iterative Reliability-Based Decoding of Low-Density Parity Check Codes", published in IEEE Journal on Selected Areas in Communications, vol. 19, no. 5, May 2001, a reliability-based decoding is combined with belief propagation decoding for low-density parity check codes. At each iteration, the soft output values delivered by the belief propagation algorithm are used as reliability values to perform reduced complexity soft decision decoding on the code considered.

In "Implementation of Near Shannon Limit Error-Correcting Codes Using Reconfigurable Hardware", published in Proceedings of IEEE Symposium on Field-Programmable Custom Computing Machines, pgs. 217-226, turbo codes and low-density parity check codes have been evaluated in terms of their implementability in hardware. It is concluded that LDPC codes are more suitable because their decoders exhibit much more exploitable parallelism.

In "Density Evolution for Two Improved BP-Based Decoding Algorithms of LDPC Codes", IEEE Communications Letters, vol. 6, no. 5, May 2202, the performance of two improved belief propagation-based decoding algorithms for LDPC codes are analyzed. The numerical calculations show that with properly chosen parameters for each of these algorithms, performances very close to the belief propagation algorithm can be achieved.

Therefore, the present invention has been designed in view of the above and other problems, and it is an object of the present invention to provide an apparatus and method for improving decoding performance of the Normalized-BP algorithm in an LDPC-code decoder.

This object is solved by the subject matter of the independent claims.

Preferred embodiments are defined in the dependent claims.

It is another aspect of the present invention to provide a decoding apparatus for use in an LDPC-code decoding apparatus, which can be implemented in the form of a simpler configuration than the LLR-BP algorithm, and a method for controlling the same.

It is yet another aspect of the present invention to provide a decoding apparatus for use in an LDPC-code decoding apparatus, which improves decoding performance of the Normalized-BP algorithm and at the same time provides similar performance to that of the LLR-BP algorithm, and a method for controlling the same.

## BRIEF DESCRIPTION OF THE DRAWINGS

The above and other objects, features, and advantages of the present invention will be more clearly understood from the following detailed description taken in conjunction with the accompanying drawings, in which:

Fig. 1 is a conceptual diagram illustrating a relationship between check nodes and variable nodes to explain a factor process for decoding the LDPC code;

Fig. 2 is a flow chart illustrating the Normalized-BP algorithm from among a plurality of LDPC-code decoding methods;

Fig. 3 is a simulation result graph for a comparison between performances according to methods for decoding an LDPC code having a block length of 20000;

Fig. 4 is a flow chart illustrating a control method for use in an LDPC-code decoder in accordance with a preferred embodiment of the present invention;

Fig. 5 is a block diagram illustrating the LDPC-code decoder in accordance with a preferred embodiment of the present invention; and

Fig. 6 is a graph illustrating an SNR simulation result among the inventive algorithm, the LLR-BP algorithm, and the Normalized-BP algorithm when decoding an LDPC code having a block length of 20000 in accordance with a preferred embodiment of the present invention.

## DETAILED DESCRIPTION OF THE PREFERRED EMBODIMENTS

Preferred embodiments of the present invention will be described in detail herein below with reference to the annexed drawings. In the drawings, the same or similar elements are denoted by the same reference numerals even though they are depicted in different drawings. In the following description, a detailed description of known functions and configurations incorporated herein will be omitted when it may make the subject matter of the present invention rather unclear.

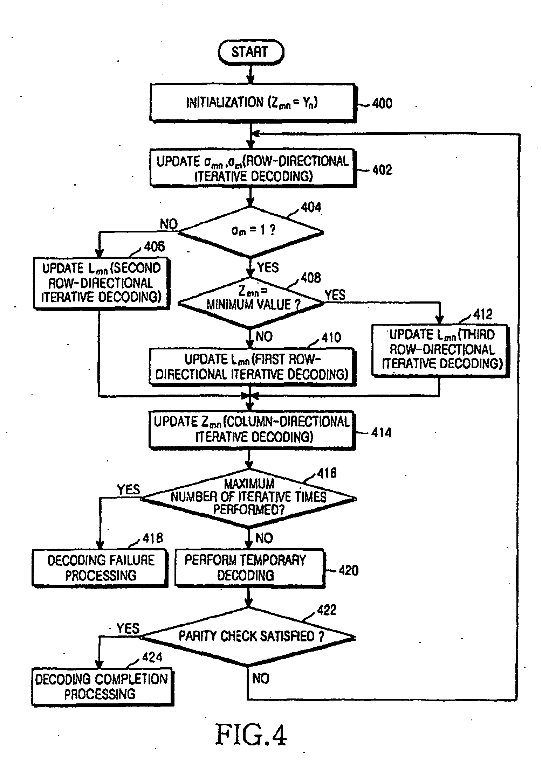

Fig. 4 is a flow chart illustrating a control method for use in an LDPC-code decoder in accordance with a preferred embodiment of the present invention. Referring to Fig. 4, the LDPC decoder performs an initialization process at step 400. This initialization process is the same as that of the conventional art illustrated in Fig. 2. After performing the initialization process at step 400, the LDPC decoder perform a row-directional iterative decoding process for updating values $\sigma_{mn}$ and $\sigma_m$ at step 402 in the same manner as described in conjunction with Fig. 2. More specifically, the LDPC decoder calculates the sum of coded symbols received in a specific check node from among individual bit nodes using the mod-2 scheme as shown in Equation 1. According to the check result of a value $Z_{mn}$ using the aforementioned calculation, there arise a first case of $\sigma_{mn}=0$ and a second case of $\sigma_{mn}=1$. The first case of $\sigma_{mn}=0$ indicates the absence of errors, and the second case of $\sigma_{mn}=1$ indicates the presence of errors.

After calculating the values of $\sigma_m$ and $\sigma_{mn}$ at step 402, , the LDPC decoder determines whether the value of $\sigma_n$ is equal to '1' at step 404. Step 404 determines whether the value of $\sigma_m$ is equal to '1' is determined by LDPC-code characteristics. The value of $\sigma_m$ calculated at a specific time while performing either all reception coded symbols or an iterative decoding process has always been designed to be the value of 1 when there are errors. However, the value of $\sigma_m$ comprises the sum of several values, instead of only one value, such that there are two cases in which the value of $\sigma_m$ has the value of 1. More specifically, the first case occurs when the probability of generating such errors is in a low level. The second case occurs when the probability of generating such errors is in a high level.

Accordingly, if the check result of the above step 404 corresponds to the aforementioned two cases, i.e., if the value of $\sigma_m$ has the value of 1, the LDPC decoder proceeds to step 408. However, if the check result of the step 404 does not correspond to the two cases, the LDPC decoder proceeds to step 406. If the LDPC decoder proceeds to step 406, this means there are no errors, such that it performs a second iterative decoding process in a row direction according to the present invention. In this case, the second iterative decoding process can be denoted by Equation 6:

$$[\text{Equation 6}]$$

$$(-1)^{\overline{\sigma_m \oplus \sigma_{mn}}} \min_{n' \in N(m) \backslash n} \left| z_{mn'} \right| / \alpha_2$$

Equation 6 has a value of a different from that of Equation 2 described in the conventional art. The present invention more precisely divides the tanh-curve standardization step for reducing the number of LLR-value calculations on the basis of the aforementioned reference. Therefore, the present invention more precisely divides not only a standardization factor used when only one or more odd errors occur, but also other factors, such that it can determine an appropriate factor value. The first case in which there is an error in factor values, and the remaining cases having no error in such factor values will be described in more detail herein below.

The LDPC decoder performs a row-directional iterative decoding process using a second standardization factor $\alpha_2$ shown in Equation 6 at step 406.

If the value of $\sigma_m$ is equal to '1', the LDPC decoder determines whether the value of $Z_{mn}$ is a minimum value at step 408. If it is determined that the value of $Z_{mn}$ is the minimum value at step 408, the LDPC decoder proceeds to step 412. However, if the value of $Z_{mn}$ is not equal to the minimum value at step 408, the LDPC decoder proceeds to step 410.

Because the value of $Z_{mn}$ is an LLR value, it has high error generation probability on the condition that the value of $Z_{mn}$ is equal to the minimum value. Therefore, if the value of $Z_{mn}$ is equal to the minimum value, the LDPC decoder proceeds to step 412, such that it performs a row-directional iterative decoding process using a third standardization factor according to the present invention at step 412. A method for performing the row-directional iterative decoding using the third standardization factor can be represented by the following equation 7:

$$[\text{Equation 7}]$$

$$(-1)^{\overline{\sigma_m \oplus \sigma_{mn}}} \min_{n' \in N(m) \backslash n} \left| z_{mn'} \right| / \alpha_3$$

Equation 7 has a value of $\alpha$ different from that of Equation 2 described in the conventional art. If the value of $Z_{mn}$ is not equal to the minimum value, i.e., if error generation probability is low, the LDPC decoder proceeds to step 410, such that it performs the row-directional iterative decoding process using the first standardization factor $\alpha_1$, as shown in Equation 8:

[Equation 8]

$$(-1)^{\overline{\sigma_m \oplus \sigma_{mn}}} \min_{n' \in N(m)\backslash n} \left| z_{mn'} \right| / \alpha_1$$

Individual standardization factors can be represented by Equation 9:

[Equation 9]

$$\alpha_1 > \alpha_2 > \alpha_3$$

The second standardization factor $\alpha_2$ from among individual standardization factors of the present invention may be equal to the standardization factor $\alpha$ described in the conventional art, and may have other values different from the standardization factor $\alpha$. Individual standardization factors of the present invention must always maintain the relationship denoted by Equation 9, regardless of the second standardization factor $\alpha_2$.

The LDPC decoder proceeds to step 414 after the row-directional iterative decoding process has been completed at step 406, 410, or 412. The LDPC decoder performs a column-directional iterative decoding process for updating the value of $Z_{mn}$ equal to the aforementioned LLR. The column-directional iterative decoding process performs an iterative decoding process using Equation 3 in the same manner as in the conventional art.

Upon completing the column-directional iterative decoding process, the LDPC decoder proceeds to step 416, such that it determines whether the number of current iterative times reaches a maximum number of iterative times at step 416. If it is determined that the number of current iterative times is equal to the maximum number of iterative times at step 416, the LDPC decoder informs corresponding reception coded symbols of a decoding failure at step 418 in such a way that it performs a corresponding process accompanied with the decoding failure.

However, if the number of current iterative times does not reach the maximum number of iterative times at step 416, the LDPC decoder proceeds to step 420, such that it performs a temporary decoding process as shown in Equation 4. The LDPC decoder proceeds to step 422, such that it performs a parity check process using the temporary decoded result. If the parity check process has been satisfied according to the parity check result, the LDPC decoder finishes decoding currently-received coded symbols at step 424. However, if the parity check process has not been satisfied according to the parity check result, the LDPC decoder returns to step 402, such that it repeats the above described steps 402 to 422. As a result, the LDPC decoder can more correctly decode the LDPC.

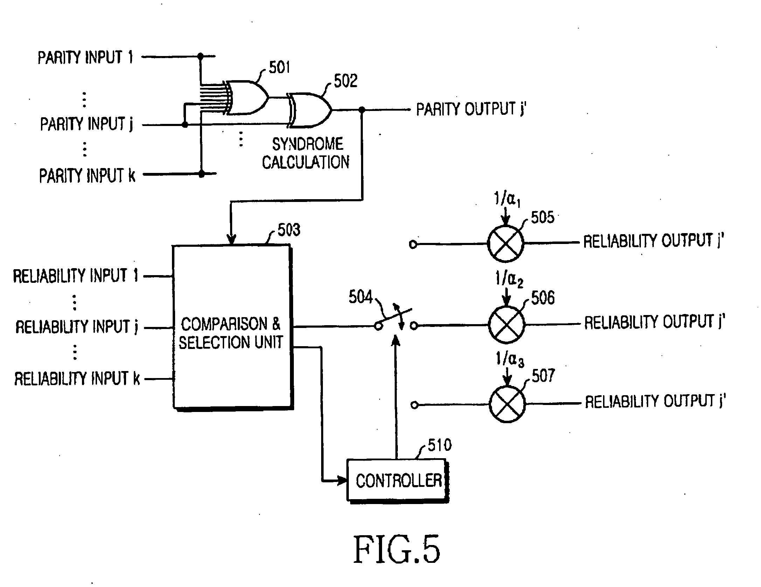

Fig. 5 is a block diagram illustrating the LDPC-code decoder in accordance with a preferred embodiment of the present invention. Referring to Fig. 5, two operators 501 and 502 for calculating syndrome values, upon receiving parity input values, are syndrome calculators that can also be used for the Normalized-BP algorithm described in the conventional art, such that their detailed descriptions will herein be omitted for the convenience of description. However, it should be noted that the present invention enters the syndrome value in a Comparison & Selection unit 503, whereas the conventional art uses the syndrome value calculated by the Normalized-BP algorithm as a parity output value only. The Comparison & Selection unit 503 receives reliability values of individual coded symbols as input values. The Comparison & Selection unit 503 selects one reliability value from among the reliability values using the parity output value, and outputs the selected reliability value. The output reliability value of the Comparison & Selection unit 503 is determined to be reliability of a bit having a lowest LLR from among a plurality of bits associated with the parity check equation, such that the Comparison & Selection unit 503 outputs the determined reliability value.

The selected value is transmitted to a controller 510 and a switch 504. The controller 510 outputs a switching control signal using the output value of the Comparison & Selection unit 503. The controller 510 uses the output value of the Comparison & Selection unit 503 as reliability values, such that it may directly receive/process such reliability values if needed. The controller 510 determines whether the value of $\sigma_m$ illustrated in Fig. 4 is equal to '1'. If it is determined that the value of $\sigma_m$ is equal to '1', the controller 510 calculates the received value to determine whether the value of $Z_{mn}$ is equal to a minimum value. If it is determined that the value of $Z_{mn}$ is not equal to the minimum value, the controller 510 outputs a switching control signal to connect the switch 504 to a second multiplier 506. If the value of $Z_{mn}$ is equal to the minimum value, the controller 510 outputs a switching control signal to connect the switch 504 to a third multiplier 507. If the value of $Z_{mn}$ is not equal to the minimum value, the controller 510 outputs a switching control signal. In the meantime, if it is determined that the value of $\sigma_m$ is not equal to '1', the controller 510 outputs a switching control signal to connect the switch 504 to a first multiplier 505.

As stated above, the number of output terminals of the switch 504 is 3, and individual multipliers 505, 506, and 507 are connected to individual output terminals. The first multiplier 505 adapts a predetermined value to be divided by the first standardization factor $\alpha_1$ as another input value, the second multiplier 506 adapts a predetermined value to be divided by the second standardization factor $\alpha_2$ as another input value, and the third multiplier 507 adapts a predetermined value to be divided by the third standardization factor $\alpha_2$ as another input value. Therefore, the value passing through the switch 504 after having been generated from the Comparison & Selection unit 503 is divided by a corresponding factor, such that it is generated in the form of changed reliability values of the present invention. It should be noted that a temporary decoding and its associated parity check devices are not shown in the annexed drawings because the temporary decoding and its associated parity check devices can also be implemented in the form of the same configuration as in the conventional art.

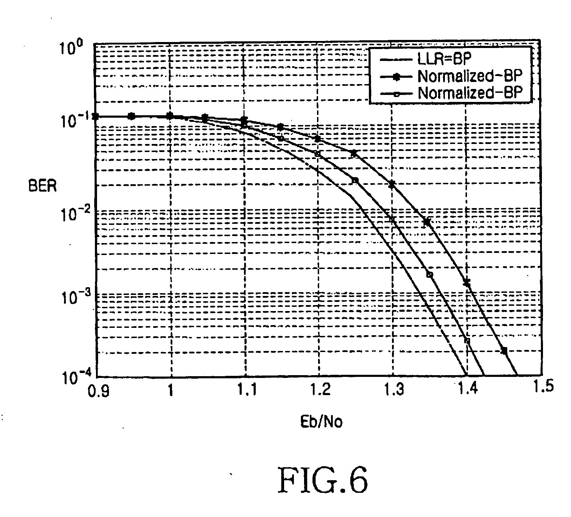

Fig. 6 is a graph illustrating an SNR simulation result among the inventive algorithm, the LLR-BP algorithm, and the Normalized-BP algorithm in the case of decoding an LDPC code having a block length of 20000 in accordance with a preferred embodiment of the present invention. The inventive graph is denoted by "Modified Normalized-BP" in Fig. 6. As can be seen from Fig. 6, the inventive method of the present invention can improve decoding-process performance much more than the conventional Normalized-BP algorithm. The algorithm compared with the Normalized-BP algorithm does not require additional multiplication operation, except for a process selecting an appropriate standardization factor value, such that it also has advantages of the conventional Normalized-BP algorithm in association with complexity. As can be seen from the simulation result of Fig. 6, the inventive method approximates about 0.02dB of the LLR-BP algorithm at the same complexity as in the Normalized-BP algorithm.

As apparent from the above description, the present invention is adapted to the LDPC-code decoding process for use in a communication system, such that it can prevent performance deterioration and can also perform such a decoding operation using only a simple circuit configuration.

Although the preferred embodiments of the present invention have been disclosed for illustrative purposes, those skilled in the art will appreciate that various modifications, additions and substitutions are possible, without departing from the scope of the invention as disclosed in the accompanying claims.

**Claims**

1. A Low Density Parity Check, hereinafter referred to as LDPC, -code decoding apparatus for decoding LDPC-coded symbols, comprising:

   a syndrome calculator (501, 502) for receiving decision values of the coded symbols, calculating a syndrome value using the received decision values, and outputting the calculated syndrome value as a parity output;
   a comparison/selection unit (503) for receiving channel reliability values of the coded symbols, receiving the syndrome value, selecting a reliability value having a lowest Log-Likelihood Ratio, hereinafter referred to as LLR, from among the channel reliability values, and outputting the selected reliability value;
   a switch (504) for switching the selected reliability value of the comparison/selection unit to one of three output terminals according to one of first to third switching control signals, respectively;
   first through third multipliers (505, 506, 507) in which the three output terminals of the switch are connected to a first standardization factor $\alpha_1$, a second standardization factor $\alpha_2$, and a third standardization factor $\alpha_3$ respectively, for outputting the selected, standardized reliability value; and
   a controller (510) for receiving the output value from the comparison/selection unit, and generating the one of the first to third switching control signals according to a predetermined condition.

2. The apparatus according to claim 1, wherein the predetermined condition comprises:

   a first condition in which the first switching control signal connects the output value of the comparison/selection unit to the second multiplier when a a value resulting from modulo-2-operation on decision values is equal to '0';
   a second condition in which the second switching control signal connects the output value of the comparison/selection unit to the third multiplier when the modulo-operation result is equal to '1' and an LLR value propagating from a bit node to a check node is equal to the minimum value, and
   a third condition in which the third switching control signal connects the output value of the comparison/selection unit to the first multiplier when the modulo-operation result is equal to '1' and said LLR value propagating from the bit node to the check node is not equal to the minimum value.

3. The apparatus according to claim 1, wherein the first standardization factor $\alpha_1$ is higher than the second standardization factor $\alpha_2$, which is higher than the third standardization factor $\alpha_3$.

4.  The apparatus according to claim 1, further comprising:

    a temporary decoder (420) for performing a temporary decoding process using the channel value and the selected, standardized reliability values, and terminating the decoding process of symbols.

5.  The apparatus according to claim 1, further comprising:

    a temporary decoder (420) for performing a temporary decoding process using the channel value and the selected, standardized reliability output values, and performing an iterative decoding process according to the temporary decoding result.

6.  The apparatus according to claim 5, wherein the apparatus further includes:

    a counter for determining whether a number of the iterative decoding times reaches a predetermined number of decoding times, increasing its counter value for every decoding operation, and further performing a decoding failure process when the decoding process is not completed until the counter value reaches a predetermined value.

7.  A Low Density Parity Check, hereinafter referred to as LDPC, -code decoding method for decoding LDPC-coded symbols, comprising the steps of:

    a) receiving coded symbols;
    b) performing initialization (400) of bit node values $z_{mn}$ using individual values of the received coded symbols;
    c) modulo-2-summing (402) decision values, which are based on bit node values $z_{mn}$, for determining values $\sigma_m$ of individual check nodes;
    d) determining (404) whether the determined values $\alpha_m$ are each equal to a specific value of 0;
    e) performing(406) a row-directional iterative decoding process for calculating values $L_{mn}$, whereby $L_{mn}$ denotes a value propagating from a check node 'm' to a bit node 'n', using a second standardization factor $\alpha_2$ when the value of 0 is determined at the step (d);
    f) determining (408) whether a current bit node value $z_{mn}$ is equal to a minimum value when the value of 1 is determined at the step (d);
    g) performing (410) a row-directional iterative decoding process for calculating values $L_{mn}$ using a first standardization factor $\alpha_1$ when the current bit node value $Z_{mn}$ is not equal to the minimum value;
    h) performing (412) a row-directional iterative decoding process for calculating values $L_{mn}$ using a third standardization factor $\alpha_3$, when the current bit node value $Z_{mn}$ is equal to the minimum value;
    i) upon receiving a first iterative decoding result of the step (e), a second iterative decoding result of the step (g), and a third iterative decoding result of the step (h), performing (414) a column-directional iterative decoding process for updating bit node values $Z_{mn}$ using $L_{m'n}$ values whereby m'≠m; and
    j) performing (420) a temporary decoding process using the column-directional iterative decoding result of the step (i), and performing (422) a parity check operation.

8.  The method according to claim 7, wherein the first standardization factor $\alpha_1$ is higher than the second standardization factor $\alpha_2$, which is higher than the third standardization factor $\alpha_3$.

9.  The method according to claim 7, wherein the row-directional iterative decoding process of step (e) is calculated by:

$$(-1)^{\overline{\sigma_m \oplus \sigma}}{}_{mn} \min{}_{n' \in N(m) \setminus n} |Z_{mn'}| / \alpha_2$$

    where $\sigma_{mn}$ represents values received by a check node 'm' from a bit node 'n', $\sigma_m$ is a value determined by a check node 'm', $Z_{mn}$ is an LLR of the bit 'n' propagated from the bit 'n' to a parity check equation 'm', and $\alpha_2$ is the second standardization factor.

10. The method according to claim 7, wherein the row-directional iterative decoding process of step (g) is calculated by:

$$(-1)^{\overline{\sigma_m \oplus \sigma}}{}_{mn} \min{}_{n' \in N(m) \setminus n} | Z_{mn'} | / \alpha_3$$

where $\sigma_{mn}$ represents values received by a check node 'm' from a bit node 'n', $\sigma_m$ is a value determined by a check node 'm', $Z_{mn}$ is an LLR of the bit 'n' propagated from the bit 'n' to a parity check equation 'm', and $\alpha_3$ is the third standardization factor.

**11.** The method according to claim 7, wherein the row-directional iterative decoding process of step (h) is calculated by:

$$(-1)^{\overline{\sigma_m \oplus \sigma}}{}_{mn} \min{}_{n' \in N(m) \setminus n} | Z_{mn'} | / \alpha_1$$

where $\sigma_{mn}$ represents values received by a check node 'm' from a bit node 'n', $\sigma_m$ is a value determined by a check node 'm', $Z_{mn}$ is an LLR of the bit 'n' propagated from the bit 'n' to a parity check equation 'm', and $\alpha_1$ is a first standardization factor.

**12.** The method according to claim 7, further comprising the step of:

k) if the parity check (422) result indicates a parity error occurrence, repeating the steps (c) to (j) a predetermined number of times.

**Patentansprüche**

**1.** Eine Low-Density-Parity-Check, hiernach bezeichnet als LDPC, Codedekodiervorrichtung für das Dekodieren von LDPC-codierten Symbolen, beinhaltend:

einen Syndromberechner (501, 502) zum Empfangen von Entscheidungswerten der codierten Symbole, Berechnen eines Syndromwertes unter Benutzung der empfangenen Entscheidungswerte und Ausgeben des berechneten Syndromwertes als ein Paritätsausgabewert;
eine Vergleichs/Auswahl-Einheit (503) zum Empfangen von Kanal-Verlässlichkeitswerten der codierten Symbole, Empfangen des Syndromwertes, Auswählen eines Verlässlichkeitwertes unter den Kanal-Verlässlichkeitswerten, der ein niedrigstes Log-Likelihood-Verhältnis, hiernach bezeichnet als LLR, aufweist und Ausgeben des ausgewählten Verlässlichkeitswertes;
einen Schalter (504) zum Schalten des ausgewählten Verlässlichkeitswertes der Vergleichs/Auswahl-Einheit zu einer von drei Ausgabevorrichtungen, jeweils entsprechend einem der von ersten bis dritten Schaltkontrollsignalen;
erste bis dritte Multiplizierer (505, 506, 507) in welchen die drei Ausgabevorrichtungen des Schalters mit jeweils einem ersten Standardisierungsfaktor $\alpha_1$, einem zweiten Standardisierungsfaktor $\alpha_2$ und einem dritten Standardisierungsfaktor $\alpha_3$ zum Ausgeben des ausgewählten standardisierten Verlässlichkeitswertes verbunden sind; und
eine Kontrollbaugruppe (510) zum Empfangen des Ausgabe-Wertes von der Vergleichs/Auswahl-Einheit und Erzeugen von einem der ersten bis dritten Schaltkontrollsignale entsprechend einer vorgegebenen Bedingung.

**2.** Die Vorrichtung gemäß Anspruch 1, worin die vorgegebene Bedingung beinhaltet:

eine erste Bedingung, in welcher das erste Schaltkontrollsignal den Ausgabewert der Vergleichs/Auswahl-Einheit mit dem zweiten Multiplizierer verbindet, wenn ein Wert, der sich aus einer Modulo-2-Operation der Entscheidungswerte ergibt, gleich 0 ist;
eine zweite Bedingung, in welcher das zweite Schaltkontrollsignal den Ausgabewert der Vergleichs/Auswahl-Einheit mit dem dritten Multiplizierer verbindet, wenn das Ergebnis der Modulo-Operation gleich 1 ist und wenn ein LLR-Wert, der von einem Bitknoten zu einem Kontrollknoten propagiert, gleich dem Minimalwert ist, und
eine dritte Bedingung, in welcher das dritte Schaltkontrollsignal den Ausgabewert der Vergleichs/Auswahl-Einheit mit dem ersten Multiplizierer verbindet, wenn das Ergebnis der Modulo-Operation gleich 1 ist und besagter LLR-Wert, der von dem Bitknoten zu dem Kontrollknoten propagiert, nicht gleich dem Minimalwert ist.

**3.** Die Vorrichtung gemäß Anspruch 1, worin der erste Standardisierungsfaktor $\alpha_1$ größer ist als der zweite Standardisierungsfaktor $\alpha_2$, welcher größer ist als der dritte Standardisierungsfaktor $\alpha_3$.

**4.** Die Vorrichtung gemäß Anspruch 1, weiter beinhaltend:

einen temporären Dekodierer (420) für das Durchführen eines temporären Dekodierprozesses unter Benutzung des Kanalwertes und des ausgewählten, standardisierten Verlässlichkeits-Wertes, und Beenden des Dekodierungsprozess der Symbole.

**5.** Die Vorrichtung gemäß Anspruch 1, weiter beinhaltend:

einen temporären Dekodierer (420) für das Durchführen eines temporären Dekodierprozesses, unter Benutzung des Kanalwertes und des ausgewählten, standardisierten Verlässlichkeitsausgabewertes, und Durchführen eines iterativen Dekodierprozesses gemäß des temporären Dekodierergebnisses.

**6.** Die Vorrichtung gemäß Anspruch 5, worin die Vorrichtung weiter beinhaltet:

einen Zähler zum Ermitteln, ob eine Anzahl der iterativen Dekodier-Wiederholungen eine vorbestimmte Anzahl von Dekodier-Wiederholungen erreicht, Erhöhen des Zählerwertes bei jeder Dekodieroperation, und weiterhin Durchführen eines Dekodier-Fehler-Prozesses, wenn der Dekodierprozess nicht beendet ist, bis der Zählerwert einen vorbestimmten Wert erreicht.

**7.** Ein Low-Density-Parity-Check, hiernach bezeichnet als LDPC, -Codedekodierverfahren für das Dekodieren von LDPC-codierten Symbolen, umfassend die Schritte:

a) Empfangen von codierten Symbolen;
b) Durchführen der Initialisierung (400) der Bitknotenwerte $Z_{MN}$ unter Benutzung individueller Werte der empfangenen codierten Symbole;
c) Modulo-2-Summieren (402) von Entscheidungswerten, die auf Bitknotenwerten $Z_{mn}$ basieren, für das Ermitteln von Werten $\sigma_m$ von individuellen Kontrollknoten;
d) Ermitteln (404), ob die ermittelten Werte $\sigma_m$ jeweils gleich einem spezifischen Wert von 0 sind;
e) Durchführen (406) eines zeilengerichteten iterativen Dekodierprozesses für das Berechnen von $L_{mn}$-Werte, wobei $L_{mn}$ einen Wert bezeichnet, der von einem Kontrollknoten m zu einem Bitknoten n propagiert, unter Benutzung eines zweiten Standardisierungsfaktors $\alpha_2$, wenn in dem Schritt d) der Wert 0 ermittelt wurde;
f) Ermitteln (408), ob ein derzeitiger Bitknotenwert $Z_{mn}$ gleich einem Minimalwert ist, wenn in dem Schritt d) der Wert von 1 ermittelt wurde;
g) Durchführen (410) eines zeilengerichteten iterativen Dekodiervorgangs für das Berechnen der $L_{mn}$-Werte unter Benutzung einen ersten Standardisierungsfaktors $\alpha_1$, wenn der gegenwärtige Bitknotenwert $Z_{mn}$ nicht gleich dem Minimalwert ist;
h) Durchführen (412) eines zeilengerichteten iterativen Dekodiervorgangs für das Berechnen der $L_{mn}$-Werte unter Benutzung einen dritten Standardisierungsfaktors $\alpha_3$, wenn der derzeitige Bitknotenwert $Z_{mn}$ gleich dem Minimalwert ist;
i) Auf das Erhalten eines ersten iterativen Dekodierergebnisses aus dem Schritt e), eines zweiten iterativen Dekodierergebnisses aus dem Schritt g) und eines dritten iterativen Dekodierergebnisses aus dem Schritt h) hin, Durchführen (414) eines zeilengerichteten iterativen Dekodierprozesses für das Aktualisieren der Bitknotenwerte $Z_{mn}$, unter Benutzung die Werte $L_{m'n}$, wobei m' ungleich m ist; und
j) Durchführen (420) eines temporären Dekodiervorgangs, unter Benutzung des Ergebnisses des zeilengerichteten iterativen Dekodierprozesses aus Schritt i) und Durchführen (422) einer Paritätskontrolloperation.

**8.** Das Verfahren gemäß Anspruch 7, wobei der erste Standardisierungsfaktor $\alpha_1$ größer ist als der zweite Standardisierungsfaktor $\alpha_2$, der größer ist als der dritte Standardisierungsfaktor $\alpha_3$.

**9.** Das Verfahren gemäß Anspruch 7, wobei der zeilengerichtete iterative Dekodiervorgang des Schrittes e) berechnet ist gemäß:

$$(-1)^{\overline{\sigma_m \oplus \sigma_{mn}}} \min_{n' \in N(m) \setminus n} |Z_{mn'}| / \alpha_2 \ ,$$

wobei $\sigma_{mn}$ Werte repräsentiert, die durch einen Kontrollknoten m von einem Bitknoten n empfangen wurden, $\sigma_m$ ist ein Wert, der durch einen Kontrollknoten m bestimmt wird, $Z_{mn}$ ist ein LLR des Bits n welcher von dem Bit n zu einer Paritätskontrollgleichung m propagiert, und $\alpha_2$ ist der zweite Standardisierungsfaktor.

**10.** Das Verfahren gemäß Anspruch 7, wobei der zeilengerichtete iterative Dekodiervorgang des Schrittes g) berechnet wird gemäß:

$$(-1)^{\overline{\sigma_m \oplus \sigma_{mn}}} \min_{n' \in N(m) \setminus n} |Z_{mn'}| / \alpha_3 \quad ,$$

wobei $\sigma_{mn}$ Werte repräsentiert, die durch einen Kontrollknoten m von einem Bitknoten n empfangen wurden, $\sigma_m$ ein Wert ist, der von einem Kontrollknoten m bestimmt wird, $Z_{mn}$ ist ein LLR des Bits n, welcher von dem Bit n zu einer Paritätskontrollgleichung m propagiert, und $\alpha_3$ der dritte Standardisierungsfaktor ist.

**11.** Das Verfahren gemäß Anspruch 7, wobei der zeilengerichtete iterative Dekodiervorgang des Schrittes h) berechnet wird gemäß:

$$(-1)^{\overline{\sigma_m \oplus \sigma_{mn}}} \min_{n' \in N(m) \setminus n} |Z_{mn'}| / \alpha_1 \quad ,$$

wobei $\sigma_{mn}$ Werte repräsentiert, die durch einen Kontrollknoten m von einem Bitknoten n empfangen wurden, $\sigma_m$ ein Wert ist, der von einem Kontrollknoten m bestimmt wird, $Z_{mn}$ ist ein LLR des Bits n, welcher von dem Bit n zu einer Paritätskontrollgleichung m propagiert, und $\alpha_1$ der erste Standardisierungsfaktor ist.

**12.** Das Verfahren gemäß Anspruch 7, weiter beinhaltend den Schritt:

k) wenn das Ergebnis der Paritätskontrolle (422) das Auftreten eines Paritätsfehlers anzeigt, Wiederholen der Schritte c) bis j) für eine vorbestimmte Anzahl von Wiederholungen.

## Revendications

**1.** Appareil de décodage de code LDPC (pour *« Low Density Parity Check »* - Contrôle de parité à faible densité), destiné à décoder des symboles codés par LDPC, comprenant :

un calculateur de syndrome (501, 502) destiné à recevoir des valeurs de décision pour les symboles codés, à calculer une valeur de syndrome en utilisant les valeurs de décision reçues et à fournir en sortie la valeur de syndrome calculée comme sortie de parité ;
une unité de comparaison et de sélection (503), destinée à recevoir des valeurs de fiabilité de canal pour les symboles codés, à recevoir la valeur de syndrome, à sélectionner dans les valeurs de fiabilité de canal une valeur de fiabilité ayant le rapport de log-probabilité le plus faible, ci-après le rapport LLR (pour « *Log-Likelihood Ratio »),* et à fournir en sortie la valeur de fiabilité sélectionnée ;
un commutateur (504), destiné à commuter la valeur de fiabilité sélectionnée par l'unité de comparaison et de sélection vers l'une des trois bornes de sortie, en fonction de l'un de trois signaux de commande de commutation, respectivement ;
trois multiplicateurs (505, 506, 507) par lesquels les trois bornes de sortie du commutateur sont connectées à un premier facteur de normalisation $\alpha_1$, un deuxième facteur de normalisation $\alpha_2$ et un troisième facteur de normalisation $\alpha_3$, respectivement, afin de fournir en sortie la valeur de fiabilité sélectionnée et normalisée ; et
un contrôleur (510) destiné à recevoir la valeur de sortie de l'unité de comparaison et de sélection et à produire l'un des trois signaux de commande de commutation, en fonction d'une condition prédéterminée.

**2.** Appareil selon la revendication 1, dans lequel la condition prédéterminée comprend :

une première condition dans laquelle le premier signal de commande de commutation connecte la valeur de sortie de l'unité de comparaison et de sélection au second multiplicateur lorsqu'une valeur résultant d'une opération modulo 2 sur des valeurs de décision est égale à zéro ;

une deuxième condition dans laquelle le deuxième signal de commande de commutation connecte la valeur de sortie de l'unité de comparaison et de sélection au troisième multiplicateur lorsque le résultat de l'opération modulo 2 est égal à un et lorsqu'une valeur LLR se progageant d'un noeud de bit à un noeud de contrôle est égale à la valeur minimale ; et

une troisième condition dans laquelle le troisième signal de commande de commutation connecte la valeur de sortie de l'unité de comparaison et de sélection au premier multiplicateur lorsque le résultat de l'opération modulo 2 est égal à un et lorsque ladite valeur LLR se progageant d'un noeud de bit à un noeud de contrôle n'est pas égale à la valeur minimale.

3. Appareil selon la revendication 1, dans lequel le premier facteur de normalisation $\alpha_1$ est supérieur au deuxième facteur de normalisation $\alpha_2$, qui est lui-même supérieur au troisième facteur de normalisation $\alpha_3$.

4. Appareil selon la revendication 1, comprenant en outre :

   un décodeur temporaire (420), destiné a exécuter un processus de décodage temporaire en utilisant la valeur de canal et les valeurs de fiabilité sélectionnées et normalisées et à terminer le processus de décodage des symboles.

5. Appareil selon la revendication 1, comprenant en outre :

   un décodeur temporaire (420), destiné a exécuter un processus de décodage temporaire en utilisant la valeur de canal et les valeurs de sortie de fiabilité sélectionnées et normalisées et à réaliser un processus de décodage itératif en fonction du résultat du décodage temporaire.

6. Appareil selon la revendication 5, dans lequel l'appareil comprend en outre :

   un compteur destiné à déterminer si un nombre de temps de décodage itératif atteint un nombre prédéterminé de temps de décodage, à augmenter la valeur du compteur à chaque opération de décodage et en outre à exécuter un processus de défaillance du décodage lorsque le processus de décodage n'est pas achevé avant que la valeur du compteur n'atteigne une valeur prédéterminée.

7. Procédé de décodage de code LDPC, destiné à décoder des symboles codés par LDPC, comprenant les étapes consistant à :

   a) recevoir des symboles codés ;
   b) exécuter l'initialisation (400) de valeurs de noeud de bit $Z_{mn}$ en utilisant des valeurs individuelles des symboles codés reçus ;
   c) additionner modulo 2 (402) des valeurs de décision qui sont fondées sur des valeurs de noeud de bit $z_{mn}$, pour déterminer des valeurs $\sigma_m$ de noeuds de contrôle individuels ;
   d) déterminer (404) si les valeurs déterminées $\sigma_m$ sont chacune égale à une valeur spécifique de zéro ;
   e) exécuter (406) un processus de décodage itératif dans la direction des rangées, afin de calculer des valeurs $L_{mn}$, où $L_{mn}$ dénote une valeur se propageant d'un noeud de contrôle 'm' à un noeud de bit 'n', en utilisant un deuxième facteur de normalisation $\alpha_2$ lorsqu'une valeur zéro a été déterminée dans l'étape (d) ;
   f) déterminer (408) si une valeur courante de noeud de bit $Z_{mn}$ est égale à une valeur minimale lorsque la valeur un a été déterminée dans l'étape (d) ;
   g) exécuter (410) un processus de décodage itératif dans la direction des rangées, afin de calculer des valeurs $L_{mn}$, en utilisant un premier facteur de normalisation $\alpha_1$ lorsqu'une valeur courante de noeud de bit $z_{mn}$ n'est pas égale à la valeur minimale ;
   h) exécuter (412) un processus de décodage itératif dans la direction des rangées, afin de calculer des valeurs $L_{mn}$, en utilisant un troisième facteur de normalisation $\alpha_3$. lorsqu'une valeur courante de noeud de bit $z_{mn}$ est égale à la valeur minimale ;
   i) à réception d'un premier résultat de décodage itératif de l'étape (e), d'un deuxième résultat de décodage itératif de l'étape (g) et d'un troisième résultat de décodage itératif de l'étape (h), exécuter (414) un processus de décodage itératif dans la direction des colonnes afin de mettre à jour les valeurs de noeud de bit $z_{mn}$ en utilisant $L_{m'n}$, où $m' \neq m$ ; et
   j) exécuter (420) un processus de décodage temporaire en utilisant le résultat du décodage itératif dans la direction des colonnes de l'étape (i) et exécuter (422) une opération de contrôle de la parité.

8. Procédé selon la revendication 7, dans lequel le premier facteur de normalisation $\alpha_1$ est supérieur au deuxième facteur de normalisation $\alpha_2$, qui est lui-même supérieur au troisième facteur de normalisation $\alpha_3$.

9. Procédé selon la revendication 7, dans lequel le processus de décodage itératif dans la direction des rangées de l'étape (e) est calculé de la manière suivante :

$$(-1)^{\overline{\sigma_m \oplus \sigma}} \sigma_{mn} \min_{n' \in N(m) \backslash n} |Z_{mn'}| / \alpha_2$$

où $\sigma_{mn}$ représente des valeurs reçues par un noeud de contrôle 'm' en provenance d'un noeud de bit 'n', où $\sigma_m$ est une valeur déterminée par un noeud de contrôle 'm', où $Z_{mn}$ est une valeur LLR du bit 'n' propagée entre le bit 'n' et une équation de contrôle de parité 'm', et où $\alpha_2$ est le deuxième facteur de normalisation.

10. Procédé selon la revendication 7, dans lequel le processus de décodage itératif dans la direction des rangées de l'étape (g) est calculé de la manière suivante :

$$(-1)^{\overline{\sigma_m \oplus \sigma}} \sigma_{mn} \min_{n' \in N(m) \backslash n} |Z_{mn'}| / \alpha_3$$

où $\sigma_{mn}$ représente des valeurs reçues par un noeud de contrôle 'm' en provenance d'un noeud de bit 'n', où $\sigma_m$ est une valeur déterminée par un noeud de contrôle 'm' , où $Z_{mn}$ est une valeur LLR du bit 'n' propagée entre le bit 'n'et une équation de contrôle de parité 'm' , et où $\alpha_3$ est le troisième facteur de normalisation.

11. Procédé selon la revendication 7, dans lequel le processus de décodage itératif dans la direction des rangées de l'étape (h) est calculé de la manière suivante :

$$(-1)^{\overline{\sigma_m \oplus \sigma}} \sigma_{mn} \min_{n' \in N(m) \backslash n} |Z_{mn'}| / \alpha_1$$

où $\sigma_{mn}$ représente des valeurs reçues par un noeud de contrôle 'm' en provenance d'un noeud de bit 'n', où $\sigma_m$ est une valeur déterminée par un noeud de contrôle 'm', où $Z_{mn}$ est une valeur LLR du bit 'n' propagée entre le bit 'n' et une équation de contrôle de parité 'm', et où $\alpha_1$ est le premier facteur de normalisation.

12. Procédé selon la revendication 7, comprenant en outre l'étape consistant à :

k) si le résultat du contrôle de parité (422) indique l'occurrence d'une erreur de parité, répéter les étapes (c) à (j) un nombre de fois prédéterminé.

FIG.1

START

INITIALIZATION ($Z_{nm} = Y_n$) — 200

UPDATE $\sigma_{nm}$, $\sigma_n$ (ROW-DIRECTIONAL ITERATIVE DECODING) — 202

UPDATE $L_{nm}$ (ROW-DIRECTIONAL ITERATIVE DECODING) — 204

UPDATE $Z_{nm}$ (COLUMN-DIRECTIONAL ITERATIVE DECODING) — 206

208
MAXIMUM NUMBER OF ITERATIVE TIMES?

YES

212
DECODING FAILURE PROCESSING

NO

PERFORM TEMPORARY DECODING — 210

214
PARITY CHECK SATISFIED ?

YES

NO

216
DECODING COMPLETION PROCESSING

FIG.2

FIG.3

**FIG.4**

FIG.5

EP 1 482 643 B1

FIG.6